Europäisches Patentamt

European Patent Office

Office européen des brevets

(11) Veröffentlichungsnummer: **0 215 968**

**A1**

(12) # EUROPÄISCHE PATENTANMELDUNG

(21) Anmeldenummer: 85111987.5

(22) Anmeldetag: 21.09.85

(51) Int. Cl.⁴: **H01L 31/18** , H01L 31/02 , C23C 16/24

(43) Veröffentlichungstag der Anmeldung:
01.04.87 Patentblatt 87/14

(84) Benannte Vertragsstaaten:
**AT BE CH DE FR GB IT LI LU NL SE**

(71) Anmelder: **Leybold-Heraeus GmbH**
**Bonner Strasse 498 Postfach 51 07 60**
**D-5000 Köln 51(DE)**

(72) Erfinder: **Amlinger, Heinrich**
**Johann-Schmidt-Strasse 12**
**D-6361 Niddatal 2(DE)**

(74) Vertreter: **Leineweber, Jürgen, Dipl.-Phys.**
**Am Heidstamm 78 a**
**D-5000 Köln 40(DE)**

(54) **Einrichtung zur Herstellung von Solarzellen mit amorphes Silizium enthaltenden Schichten, Verfahren zum Betrieb dieser Einrichtung und Kathode zur Verwendung in dieser Einrichtung.**

(57) Die Erfindung bezieht sich auf ein Verfahren und eine Einrichtung zur Herstellung von Solarzellen mit amorphes Silizium enthaltenden Schichten in einer Kammer (4), in der die Siliziumschicht durch Plasmabeschichtung aufgebracht wird, indem Silan über eine Kathode (12) mit Gasaustrittsöffnungen (19) zugeführt und im Plasma zersetzt wird; um die Qualität der hergestellten Solarzellen bei gleichzeitiger Senkung der Herstellkosten zu ermöglichen, wird vorgeschlagen, die Kammer (4) mit Einrichtungen (9) zur Rückgewinnung und Reinigung des Silans auszurüsten; zweckmäßigerweise wird dazu mindestens eine Ausfriereinrichtung (36, 37, 38) verwendet.

EP 0 215 968 A1

Fig 2

0 215 968

**Einrichtung zur Herstellung von Solarzellen mit amorphes Silizium enthaltenden Schichten, Verfahren zum Betrieb dieser Einrichtung und Kathode zur Verwendung in dieser Einrichtung.**

Die Erfindung bezieht sich auf eine Einrichtung zur Herstellung von Solarzellen mit amorphes Silizium enthaltenden Schichten mit einer Kammer, in der die Silizium-Schicht durch Plasmabeschichtung aufgebracht wird, indem Silan über eine Kathode mit Gasaustrittsöffnungen zugeführt und im Plasma zersetzt wird. Außerdem bezieht sich die vorliegende Erfindung auf ein Verfahren zum Betrieb einer Einrichtung dieser Art sowie auf eine Kathode zur Verwendung in dieser Einrichtung.

Bei wolkenlosem Himmel und senkrechtem Strahlungseinfall beträgt die Strahlungsleistung der Sonne am Erdboden ca. 1 kW/m². Mit Hilfe von Solarzellen ist es möglich, einen Teil dieser Strahlungsleistung in elektrische Energie umzuwandeln. Dabei nutzt man den Effekt aus, daß in einem Halbleiter durch Lichtquanten genügend hoher Energie freie, d. h. bewegliche positive und negative Ladungsträger erzeugt werden. Diese Ladungsträger müssen anschließend durch ein internes elektrisches Feld, das z. B. durch einen p-n-Übergang erzeugt wird, räumlich getrennt werden. Schließt man an dieses Element einen elektrischen Verbraucher an, so gleichen sich die Ladungen aus; es fließt ein Strom. Eine Solarzelle kann also mit einer Batterie verglichen werden. Anders als eine Batterie erschöpft sich eine Solarzelle nicht, da ein Materialtransport nicht stattfindet; es fließen nur Elektronen. Solarzellen liefern Strom, so lange sie mit Licht ausreichender Energie beleuchtet werden. Dabei sind sie vollkommen wartungsfrei. Alterungs-bzw. Verschleißeigenschaften sind bisher nicht beobachtet worden.

Die meisten zur Zeit verfügbaren Solarzellen bzw. Solarzellenmodule sind aus krstallinen Siliziumsolarzellen aufgebaut. Dazu werden aus stabförmigen Einkristallen Scheiben von ca. 100 mm Durchmesser und etwa 0,3 mm Dicke geschnitten. Aus diesen Scheiben werden durch geeignete Prozesse Solarzellen hergestellt. Die einzelnen Zellen werden zu größeren Modulen verschaltet. In entlegenen Gebieten sind Solarzellen damit heute bereits konkurrenzfähig zu Dieselgeneratoren. Für eine großtechnische Anwendung der Solarzellen als Stromlieferanten sind diese Preise allerdings noch zu hoch.

Weltweit werden große Anstrengungen unternommen, diese Kosten pro Watt installierter Leistung zu senken, um die Solarenergie rentabler zu machen. Einen Ansatz dazu bietet die Entwicklung von Dünnschichtsolarzellen. Die amorphe Silizium-Dünnschichtsolarzelle wird heute als die interessanteste Lösung angesehen.

Bei den Dünnschichtsolarzellen aus amorphem Silizium handelt es sich um n-i-p-Dioden, bei denen die Ladungsträger, die in der i-Schicht durch Licht erzeugt werden, durch das elektrische Feld des n-i-bzw. i-p-Übergangs getrennt werden. Sie sind folgendermaßen aufgebaut:

Zunächst wird auf ein elektrisch leitfähiges Susbtrat (z. B. Al-beschichtetes Glas oder Edelstahl) eine sehr dünne Schicht (ca. 50 nm) hoch n-dotiertes Silizium aufgebracht. Dies geschieht durch Beimischen von Phosphin ($PH_3$) in geeigneter Konzentration zum Silan ($SiH_4$). Darauf wird intrinsisches, d. h. undotiertes amorphes Silizium abgeschieden (durch Zersetzung von reinem Silan). Die Dicke dieser Schicht wird mit 0,5 $\mu$m so gewählt, daß das Sonnenlicht weitgehend in dieser Schicht absorbiert wird. Als drittes folgt eine p-dotierte Schicht von 10 -20 nm Dicke. Die p-Dotierung erreicht man durch einen Zusatz von Diboran - ($B_2H_6$) zum $SiH_4$. Diesem Gasgemisch wird noch Methan ($CH_4$) in geeigneter Konzentration zugesetzt, so daß neben Bor auch Kohlenstoff in die Schicht eingebaut wird. Es entsteht p-dotiertes Si $_xC_{1-x}$. Dieses Material hat die Eigenshaft, bei hoher Leitfähigkeit eine optische Adsorption zu besitzen, die erst bei höheren Photoenergien einsetzt als bei der intrinsischen Schicht.

Durch geeignete Wahl des Mischungsverhältnisses zwischen $SiH_4$ und $CH_4$ kann man daher die Adsorptionskante der p-Schicht so einstellen, daß sie für den größten Teil des Sonnenspektrums transparent ist, der größte Teil des Sonnenlichts die aktive i-Schicht also ungehindert erreicht. Auf die p-Schicht werden Elektroden aufgebracht, die zusammen mit dem leitenden Substrat die Kontakte der Solarzelle bilden. Anschließend müssen die Zellen mit einer Deckschicht versehen werden, um sie vor Kontaktkorrosion und mechanischer Beanspruchung (Kratzer, Hagel) zu schützen.

Bei der Produktion der Solarzellen ist es wichtig, Verschleppungseffekte der Dotiergase von der einen Schicht in die nächste zu vermeiden. Dies läst sich am besten durch die Verwendung einer Dreikammeranlage erreichen, bei der für jede Einzelschicht der n-i-p-Diode ein Reaktionsraum vorhanden ist. Der Transport des Substrats von einer Kammer zur nächsten kann dabei über Vakuumschleusen erfolgen, da zwischen den einzelnen Beschichtungen keine Belüftung des Substrats erfolgen darf. Außerdem hat die Reinheit der verwendeten Gase und die Gasführung an der Kathode einen großen Einfluß auf die Qualität der Schichten und damit auf die Güte der Solarzellen. Es muß deshalb große Sorgfalt beim "Handling" und der Mischung der Gase und beim Verteilen an der Kathode aufgewendet werden.

Der vorliegenden Erfindung liegt die Aufgabe zugrunde, ein Verfahren für die Produktion von Dünschichtsolarzellen zu finden, bei dem möglichst große Stückzahlen mit großen Flächen wirtschaftlich und mit möglichst großem Wirkungsgrad produziert werden können.

Bei einer Einrichtung zur Herstellung von Solarzellen der eingangs genannten Art wird diese Aufgabe dadurch gelöst, daß der Kammer, in der die Plasmabeschichtung zum Aufbringen der Silizium-Schicht stattfindet, Einrichtungen zur Rückgewinnung und Reinigung des Silans zugeordnet sind.

Eine Silan-Recyclinganlage insbesondere für die i-Beschichtung bietet den Vorteil, daß bis zu 20 % der Produktionskosten eingespart werden können. Da außerdem das Silan bei jedem Recyclingvorgang gereinigt wird, also ein Gas höchster Reinheit für die Beschichtung zur Verfügung steht, steigt die Qualität der Beschichtung und damit der Wirkungsgrad der hergestellten Solarzellen.

Besonders vorteilhaft ist es, wenn das zu reinigende und zurückzuführende Silan mittels einer Ausfriereinrichtung aus der Beschichtungskammer abgezogen wird. Eine Einrichtung dieser Art hat die Wirkung einer Vakuumpumpe, mit der in einfacher Weise auch der Druck in der Beschichtungskammer regelbar ist. Außerdem hat das Ausfrieren des Silans bereits den gewünschten Reinigungseffekt.

Um das angestrebte Ziel, die Verbesserung des Wirkungsgrades der hergestellten Solarzellen, zu erreichen, ist eine gleichmäßige Zuführung des Silans über die Größe der Solarzellen erforderlich. Die Größe kann mehr als 1 m² betragen, so daß auch die darüber befindliche Kathode, über die die Zuführung des Silans erfolgt, diese Größe haben muß. Um bei einer Kathode dieser Art eine gleichmäßige Ausströmgeschwindigkeit des Silans aus den über die gesamte Fläche der Kathode verteilten Ausströmöffnungen zu erreichen, ist diese so aufgebaut, daß die Weglängen von der Gaszuführung bis zu sämtlichen Austrittsöffnungen gleich lang sind.

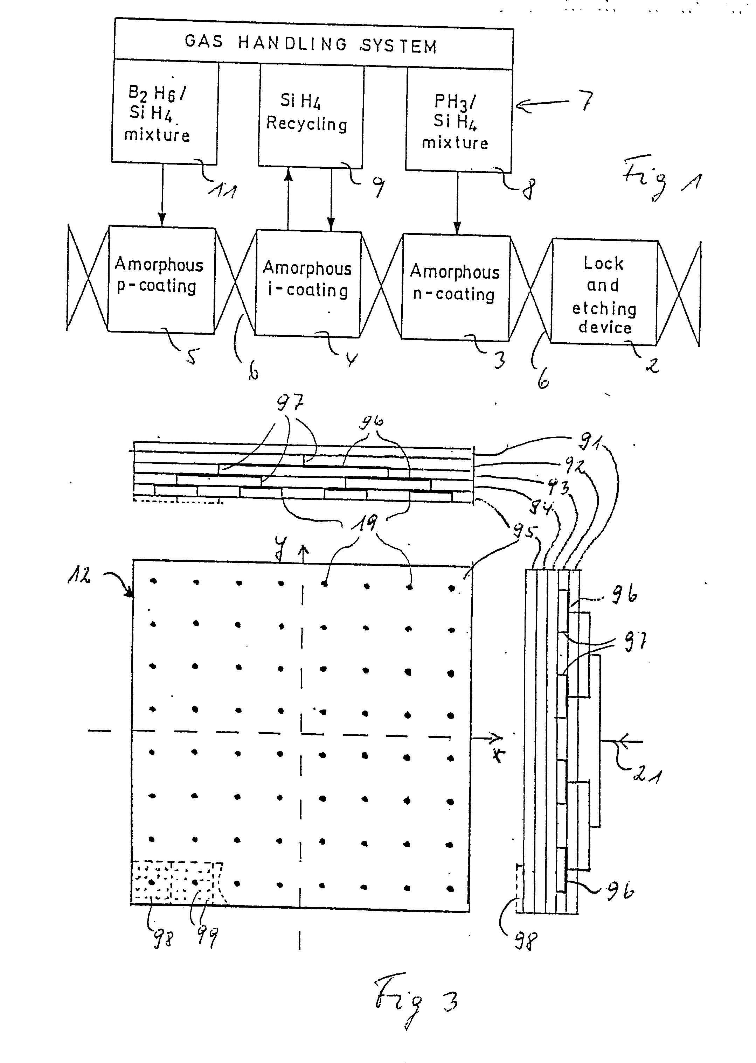

Weitere Vorteile und Einzelheiten der Erfindung sollen anhand von in den Figuren 1,2 und 3 dargestellten Ausführungsbeispielen erläutert werden.

Fig. 1 zeigt eine Blockdarstellung von Teilen einer Produktionsanlage zur Herstellung von Solarzellen. Dargestellt sind vier Kammern 2, 3, 4 und 5, die jeweils mit Absperreinrichtungen 6 ausgerüstet sind. Das auf einem Halter angeordnete Substrat wird auf einer Transporteinrichtung von rechts nach links durch die Kammern gefördert. Vor und hinter den dargestellten Teilen der Anlage befinden sich weitere Kammern z. B. zur Beladung, zur Entladung, zur Kontrolle und dergleichen.

In der ersten Kammer 2 findet ein Ätzprozeß statt, der die Oberfläche des Substrats vorbereitet. In der Kammer 3 erfolgt das Aufbringen einer n-dotierten Siliziumschicht, indem ein Gemisch aus Phosphin und Silan durch Plasmabeschichtung auf das Substrat aufgebracht wird. Nach der gleichen Methode wird die amorphe Siliziumschicht in der Kammer 4 aufgebracht, der reines Silan zugeführt wird. Das im Überschuß zugeführte Silan wird zurückgewonnen, gereinigt und wieder zugeführt. Schließlich erfolgt in der Kammer 5 das Aufbringen der p-dotierten Schicht.

Das Gashandlingsystem ist insgesamt mit 7 bezeichnet und weist die Anlagenteile 8, 9 un 11 auf, die der Aufbereitung des Phosphin-/Silangemisches (8) für die Kammer 3, der Bereitstellung des Silans (9) für die Kammer 4 und der Versorgung der Kammer 5 mit einem Gasgemisch aus Diboran und Silan dienen.

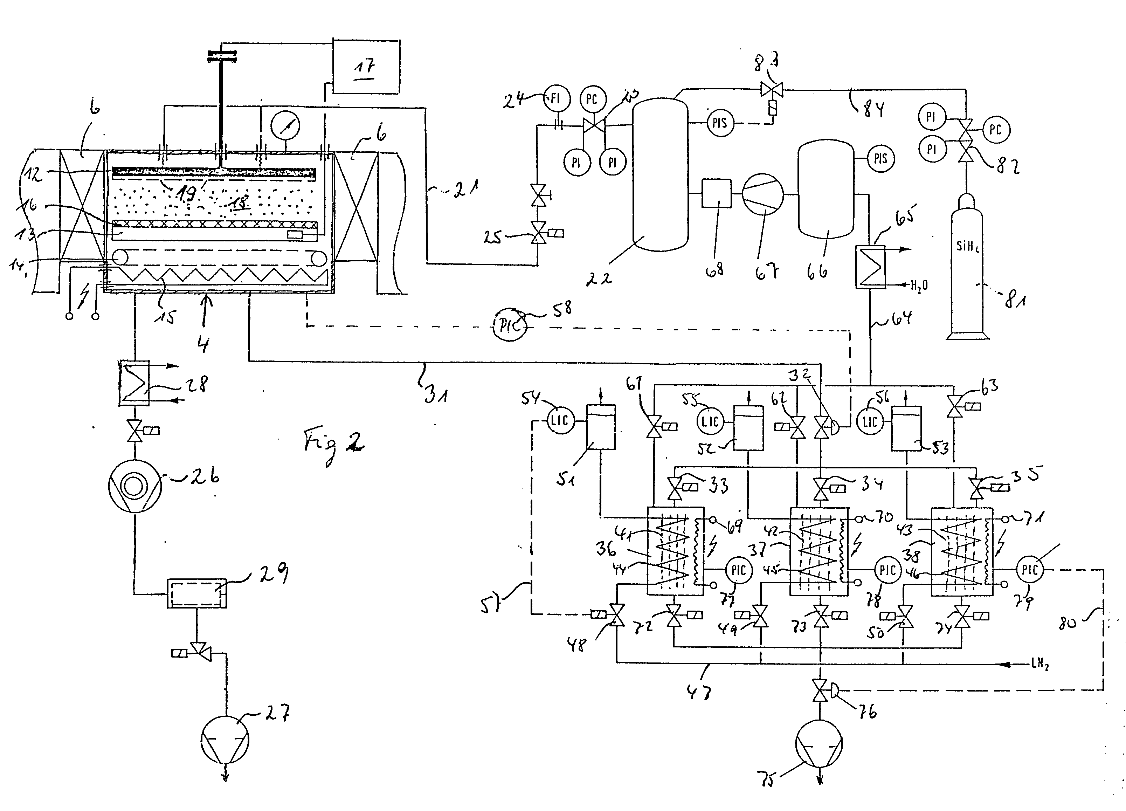

In Fig. 2 ist die Kammer 4 nochmals dargestellt. Innerhalb der Kammer 4 befinden sich die Kathode 12, der Substratträger 13, die Transporteinrichtung 14 und die Heizeinrichtung 15, die in unteren Bereich der Kammer 4 angeordnet ist und den Substratträger 13 und das darauf befindliche Substrat 16 von unten beheizt. Die Kathode 12 und der Substratträger 13 sind mit dem Hochfrequenzgenerator 17 verbunden, so daß zwischen der Kathode 12 und dem Substrat 16 das gewünschte Plasma 18 erzeugt werden kann.

Die Kathode 12 ist an ihrer Unterseite mit einer Vielzahl von Öffnungen 19 ausgerüstet, denen von der Oberseite der Kathode her über die Leitung 21 reines Silan aus dem Pufferbehälter 22 zugeführt wird. Das Silan steht im Behälter 22 unter Überdruck. In der Leitung 21 ist deshalb das Druckminderventil 23 vorgesehen. Der Kontrolle der gleichmäßigen Versorgung der Kathode 12 mit Silan dienen noch das Strömungskontrollgerät 24 und das Nadelventil 25.

Um die Kammer 4 vor der Inbetriebnahme bei gleichzeitigem Ausheizen zu evakuieren, ist ein Pumpstand vorgesehen, der die Turbomolekularpumpe 26 und die Vorpumpe 27 umfaßt. Der Turbomolekularpumpe 26 vorgeschaltet ist der Kühler 28, der die Turbomolekularpumpe vor kondensierbaren Gasen schützt. Diese entstehen während des Ausheizens und Evakuierens der Kammer 4. Zum Schutz gegen die Rückdiffusion von Öldämpfen aus der Vorpumpe 27 ist noch die Adsorptionsfalle 29 zwischen den beiden Pumpen 26 und 27 vorgesehen.

Während der Plasmabeschichtung wird ständig reines Silan zugeführt. Dieses strömt aus der Vielzahl der Öffnungen 19 an der Unterseite der Kathode 12 aus und wird über die Leitung 31 abgezogen. An die Leitung 31 schließen sich über das Regelventil 32 und die Ventile 33, 34 und 35 die Kammern 36, 37 und 38 an, in denen möglichst große,gekühlte Pumpflächen 41, 42 und 43 untergebracht sind. Diese stehen mit Kühlschlangen 44, 45 und 46 in Verbindung, die die Kammern 36, 37 und 38 von unten nach oben durchsetzen. Die Kühlschlangen werden von unten über die Leitung 47 und die Ventile 48, 49, 50 mit flüssigem Stickstoff geflutet. Oberhalb der Kammern sind Phasenscheider 51, 52 und 53 vorgesehen, die mit Niveaukontrolleinrichtungen 54, 55 ausgerüstet sind und die Flutventile 48 49 und 50 steuern. Nur eine Steuerleitung 57 ist dargestellt.

An die Kammern 36, 37 und 38 sind weiterhin Leitungen mit den Ventilen 61, 62 und 63 angeschlossen, die in die gemeinsame Leitung 64 münden. In der Leitung 64, die zum Behälter 22 führt, sind der Kühler 65, der Silan-Niederdruckbehälter 66, der ölfrei arbeitende Kompressor 67 und das z. B. mit Aktivkohle ausgerüstete Filter 68 angeordnet. Jede der Kammern 36, 37 und 38 ist außerdem mit einer Heizung 69, 70, 71 ausgerüstet, mit der die Pumpflächen aufgeheizt werden können, so daß aufgefrorenes Silan abdampft.

An die Kammern 36, 37 und 38 ist schließlich noch jeweils über die Ventile 72, 73 und 74 die Vakuumpumpe 75 angeschlossen. Der Vakuumpumpe 75 unmittelbar vorgeschaltet ist das Regelventil 76, das mit den Druckkontrolleinrichtungen 77, 78 und 79 an den Kammern 36, 37 und 38 in Verbindung steht (nur eine Verbindungleitung 80 ist dargestellt).

Mit 81 is noch ein Silvanvorratsbehälter bezeichnet, der über ein Druckreduzierventil 82 und ein vom Druck im Behälter 22 gesteuertes Ventil 83 mit dem Behälter 22 über die Leitung 84 in Verbindung steht. Dieser zusätzliche Silvanvorrat 81 dient den zwar geringen, aber unvermeidlichen Verlusten während des Betriebs der Kammer 4.

Vor der Einbringung des Subtrathalters 13 mit dem Substrat 16 wird die Kammer 4 auf einen Druck von $10^{-4}$ bis $10^{-6}$ mbar evakuiert. Nach dem Einbringen des Substrats 16 in die Kammer 4 und dem Verschließen der Absperreinrichtungen 6 wird die Kammer mit reinem Silan aus dem Behälter 22 auf ca. 0,1 bis 2 mbar geflutet und die i-Schicht durch Plasmabeschichtung aufgebracht. In dieser Phase zersetzt sich das Silan und scheidet undotiertes amorphes Silizium ab. Bei einer Frequenz von 13 MHz und einer Beschichtungszeit von ca. 15 bis 30 min entsteht eine Schichtdicke von ca. 0,5 µm.

Während der Plasmabeschichtung in der Kammer 4 ist eine der drei Kammern 36, 37 oder 38 über das Regelventil 32 an die Kammer 4 angeschlossen. Mit 58 ist eine Druckmeß-und Kontroleinrichtung bezeichnet, die in Abhängigkeit vom Druck in der Kammer 4 die Durchströmöffnung im Regelventil 32 verändert. Die Regelung erfolgt in der Weise, daß bei einer Überschreitung des vorgegebenen Druckes in der Kammer 4 das Ventil 32 öffnet, so daß mehr Gas aus der Kammer 4 durch die Pumpwirkung der angeschlossenen Kammer - (36, 37 oder 38) abgesaugt und ausgefroren wird. Bei einer Unterschreitung des gewünschten Druckes in der Kammer 4 schließt das Regelventil 32, so daß infolge der kontinuierlichen Zufuhr von Silan durch die Öffnungen 19 der Kathode 12 der Druck in der Kammer 4 ansteigt. Die Temperatur der Pumpflächen wird auf 75 bis 100 K gehalten. Auch die Vakuumpumpe 75 ist an die betroffene Kammer angeschlossen und hält den Kammerdruck auf einen Wert, der etwas unter dem Druckwert in der Beschichtungskammer 4 liegt (Regeleinrichtungen 76, 79, 80). Das über das Regelventil 32 in die betroffene Kammer gelangende Silan wird auf den großflächigen Pumpflächen ausgefroren, während die nicht ausfrierenden Bestandteile (Spaltprodukte, Wasserstoff, Kohlenwasserstoffe) von der Pumpe 75, vorzugsweise einer Drehschieberpumpe, abgepumpt werden.

Bei diskontinuierlichem Beschichtungsbetrieb in der Kammer 4 würde eine der Ausfriereinrichtungen 36, 37 oder 38 genügen. Um jedoch kontinuierlich arbeiten zu können, sind zwei, vorzugsweise drei Ausfriereinrichtungen erforderlich, so daß gleichzeitig eine der Ausfriereinrichtungen mit der Kammer 4 verbunden sein kann, während das aufgefrorene Silan aus der oder den anderen Ausfriereinrichtungen zurückgewonnen werden kann.

Um z. B. das in der Kammer 36 auf den Pumpfläche 41 aufgefrorene hochreine Silan zurückzugewinnen, wird das Ventil 33 geschlossen und die Heizung 69 eingeschaltet. Während des Abdampfens des aufgefrorenen Silans sind die Ventile 33 und 72 geschlossen. Das Ventil 61 ist geöffnet, so daß das aufgeheizte Silan durch den Kühler 65, die Niederdruckvorlage 66 strömt und mittels des Kompressors 67 auf den Druck des Behälters 22 gebracht wird. Mit Hilfe des zwischen Kompressor 67 und Behälter 22 befindlichen Filters 68 erfolgt eine Abtrennung möglicherweise noch vorhandener Kohlenwasserstoffe oder Wasserdämpfe.

Fig. 3 zeigt schematisch den Aufbau einer insbesondere bei der Beschichtung der beschriebenen großflächigen Substrate verwendbaren Kathode 12. Sie besteht aus den Schichten 91 bis 95. Die Schicht 95 bildet die Unterseite der Kathode 12 mit der Vielzahl der Ausströmöffnungen 19.

Die Schichten 91 bis 95 selbst sind mit Einfräsungen 96 (verstärkte Trennlinien zwischen den Schichten) und Bohrungen 97 (senkrecht zu den Schichten verlaufende Linienabschnitte) versehen, die insgesamt ein Gasverteilungssystem bilden, bei dem der Weg des Gases von der Zuführungsleitung 21 bis zu jeder der Ausströmöffnungen gleich lang ist.

Beim dargestellten Ausführungsbeispiel ist die Anordnung der Bohrungen 97 und Einfräsungen 96 so getroffen, daß die Schichten 91 und 92 zunächst für eine gleichmäßige Verteilung der zugeführten Gase in y-Richtung sorgen. Dazu wird das Gas vier auf der y-Achse liegenden Bohrungen in der Schicht 91 zugeführt. Die auf der Unterseite der Schicht 91 oder der Oberseite der Schicht 92 befindlichen Einfräsungen verbinden die vier Bohrungen in der Schicht 91 mit jeweils zwei ebenfalls auf der y-Achse liegenden Bohrungen in der Schicht 92. Diese insgesamt acht Bohrungen in der Schicht 92 münden in zur x-Richtung parallel liegenden Einfräsungen, über die in der im oberen Schnitt dargestellten Weise die Verteilung des Gases in x-Richtung erfolgt.

Wird bei der Herstellung der Einfräsungen 96 und Bohrungen 97 dafür gesorgt, daß der Strömungsquerschnitt im Bereich einander entsprechenden. Abschnitten stets gleich ist, dann ist ein gleichmäßiges Ausströmen des Gases aus den Öffnungen 19 in hohem Maße sichergestellt. Kathoden dieser Art mit mehr als 1 m² großer Fläche sind in einfacher Weise z. B. auf numerisch gesteuerten Werkzeugmaschinen möglich. Die Dicke der Schichten 91 bis 95 kann in der Größenordnung von Millimetern liegen, so daß großflächige ca. 1 cm dicke Kathoden herstellbar sind.

Eine weitere Verteilung der Gase kann durch Erhöhung der Schichtzahl mit weiteren Verzweigungen oder auch noch dadurch erreicht werden, daß jeder der Öffnungen 19 eine Begasungskammer 98 mit jeweils gleichmäßig verteilten Öffnungen 99 (z. B. 16) zugeordnet ist.

Recycling-Anlagen der beschriebenen Art sind vorzugsweise bei der beschriebenen i-Beschichtung von Substraten zur Herstellung von Solarzellen einsetzbar. Ist der Silananteil bei anderen Plasmabeschichtungen ausreichend hoch, dann ist der Einsatz der beschriebenen Recycling-Anlage auch dort wirtschaftlich sinnvoll.

**Ansprüche**

1. Einrichtung zur Herstellung von Solarzellen mit amorphes Silizium enthaltenden Schichten in einer Kammer (4), in der die Siliziumschicht durch Plasmabeschichtung aufgebracht wird, indem Silan über eine Kathode (12) mit Gasaustrittsöffnungen (19) zugeführt und im Plasma zersetzt wird, **dadurch gekennzeichnet,** daß der Kammer (4) Einrichtungen (9) zur Rückgewinnung und Reinigung des Silans zugeordnet sind.

2. Einrichtung nach Anspruch 1, **dadurch gekennzeichnet,** daß die Kammer (4) mit einer Ausfriereinrichtung (36) zur Rückgewinnung und Reinigung des Silans verbunden ist.

3. Einrichtung nach Anspruch 2, **dadurch gekennzeichnet,** daß mindestens zwei, vorzugsweise drei Ausfriereinrichtungen (36, 37, 38) vorgesehen sind.

4. Einrichtung nach Anspruch 3, **dadurch gekennzeichnet,** daß die Ausfriereinrichtungen jeweils aus einer Kammer bestehen, in denen vorzugsweise mit flüssigem Stickstoff gekühlte Pumpflächen (41, 42, 43) untergebracht sind.

5. Einrichtung nach Anspruch 4, **dadurch gekennzeichnet,** daß die die Pumpflächen (41, 42, 43) enthaltenden Kammern (36, 37, 38) von Kühlschlangen (44, 45, 46) durchsetzt sind, die während des Pumpbetriebes mit flüssigem Stickstoff geflutet sind.

6. Einrichtung nach einem der Ansprüche 2 bis 5,

**dadurch gekennzeichnet,** daß die Ausfriereinrichtungen (36, 37, 38) während des Betriebes an eine Vorvakuumpumpe (75) anschließbar sind.

7. Einrichtung nach einem der Ansprüche 2 bis 6,

**dadurch gekennzeichnet,** daß die Ausfriereinrichtungen mit einem Silan-Vorratsbehälter (22) über einen Kompressor (67) verbindbar sind.

8. Einrichtung nach Anspruch 7, **dadurch gekennzeichnet,** daß dem Kompressor (67) eine Kühleinrichtung (65) vorgeschaltet und ein vorzugsweise Aktivkohle enthaltendes Filter (68) nachgeordnet ist.

9. Verfahren zum Betrieb einer Einrichtung nach den Ansprüchen 2 bis 7, **dadurch gekennzeichnet,** daß mit Hilfe der an die Kammer (4) angeschlossenen Ausfriereinrichtungen (36, 37 oder 38) der Druck in der Kammer (4) geregelt wird.

10. Kathode insbesondere zur Verwendung in einer Einrichtung nach den Ansprüchen 1 bis 8, **dadurch gekennzeichnet,** daß sie ein Gasverteilungssystem enthält, bei der die Wege des Gases von der Gaszuführung (21) bis zu den an der Unterseite der Kathode befindlichen Ausströmöffnung (19) sämtlich gleich lang sind.

11. Kathode nach Anspruch 10, **dadurch gekennzeichnet,** daß sie mehrere Schichten (91 bis 95) mit Einfräsungen (96) und Bohrungen (97) zur Bildung der Gasführungskanäle aufweist.

12. Kathode nach Anspruch 11, **dadurch gekennzeichnet,** daß die Kathode fünf Schichten (91 bis 95) und vierundsechzig Ausströmöffnungen (19) im Bereich ihrer Unterseite aufweist und daß die ersten beiden Schichten (91, 92) der Verteilung des Gases in einer ersten Richtung und die sich anschließenden Schichten (93 bis 95) der Verteilung der Gase in der zur ersten Richtung senkrechten Richtung dienen.

13. Kathode nach Anspruch 12, **dadurch gekennzeichnet,** daß den Ausströmöffnungen (19) an der Unterseite der Kathode (12) jeweils eine Begasungskammer (98) mit mehreren Ausströmöffnungen (99) zugeordnet ist.

## GAS HANDLING SYSTEM

| B₂H₆/ SiH₄ mixture | SiH₄ Recycling | PH₃/ SiH₄ mixture |
|---|---|---|

$B_2H_6/$ $SiH_4$ mixture    $SiH_4$ Recycling    $PH_3/$ $SiH_4$ mixture

7

11     9     8

*Fig 1*

| Amorphous p-coating | Amorphous i-coating | Amorphous n-coating | Lock and etching device |
|---|---|---|---|

5     6     4     3     6     2

97     96     91     92     93     94     95     19

12

y     x

21

98     99     96     97     96     98

*Fig 3*

Fig 2

0 215 968

**Europäisches Patentamt**

**EUROPÄISCHER RECHERCHENBERICHT**

Nummer der Anmeldung

EP 85 11 1987

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| Y | PATENTS ABSTRACTS OF JAPAN, Band 8, Nr. 162 (C-235)[1599], 26. Juli 1984, Seite 83 C 235; & JP - A - 59 64516 (FUJI DENKI SOUGOU KENKYUSHO K.K.) 12.04.1984 * Insgesamt * | 1 | H 01 L 31/18 H 01 L 31/02 C 23 C 16/24 |
| A | idem | 2,7 | |
| Y | EXTENDED ABSTRACTS, Nr. 79/1, Mai 1979, Seiten 161-163, Abstract Nr. 59, Princeton, US; W.H. REED et al.: "Development of a process for high capacity production of solar grade silicon" * Insgesamt * | 1 | |
| A | SIEMENS FORSCHUNG UND ENTWICKLUNGSBERICHTE, Band 9, Nr. 2, 1980, Seiten 94-98, Berlin, DE; J.G. GRABMAIER et al.: "Glow discharge-deposited amorphous silicon films for low-cost solar cells" * Seiten 94-95, Abbildungen 2,3 * | 1 | RECHERCHIERTE SACHGEBIETE (Int. Cl.4) H 01 L |
| A | DE-A-2 918 066 (SIEMENS AG) * Insgesamt * | 1 | |
| | --- -/- | | |

Der vorliegende Recherchenbericht wurde für alle Patentansprüche erstellt.

| Recherchenort DEN HAAG | Abschlußdatum der Recherche 27-05-1986 | Prüfer VISENTIN A. |
|---|---|---|

Europäisches
Patentamt

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
| A | US-A-4 491 604 (I.A. LESK et al.) <br><br> ----- | | |
| | | | **RECHERCHIERTE SACHGEBIETE (Int. Cl.4)** |

Der vorliegende Recherchenbericht wurde für alle Patentansprüche erstellt.

| Recherchenort | Abschlußdatum der Recherche | Prüfer |
|---|---|---|
| DEN HAAG | 27-05-1986 | VISENTIN A. |